Europäisches Patentamt

European Patent Office

Office européen des brevets

(19)

(11) Numéro de publication: **0 140 739**
**B1**

(12) **FASCICULE DE BREVET EUROPEEN**

(45) Date de publication du fascicule du brevet:
**27.01.88**

(21) Numéro de dépôt: **84401816.8**

(22) Date de dépôt: **13.09.84**

(51) Int. Cl.⁴: **B 21 D  25/00,** C 30 B  13/18

(54) Dispositif de mise en tension d'une plaque mince.

(30) Priorité: **20.09.83  FR 8314921**

(43) Date de publication de la demande:
**08.05.85 Bulletin 85/19**

(45) Mention de la délivrance du brevet:
**27.01.88 Bulletin 88/4**

(84) Etats contractants désignés:
**DE GB IT NL**

(56) Documents cités:
**DE - C - 571 849**
**FR - A - 2 067 923**
**FR - A - 2 251 368**
**GB - A - 1 059 916**
**US - A - 3 241 352**

(73) Titulaire: **COMMISSARIAT A L'ENERGIE ATOMIQUE,
31/33, rue de la Fédération, F-75015 Paris (FR)**

(72) Inventeur: **Aubert, Jean-Jacques, Résidence
Beauséjour, F-38120 Fontanil Par Saint Egreve (FR)**
Inventeur: **Basset, Alain, 48, Boulevard Joseph Vallier,
F-38100 Grenoble (FR)**
Inventeur: **Bechevet, Bernard, Lotissement "La
Cascade", F-38640 Claix Cidex (FR)**
Inventeur: **Roulin, Claude, 12, Place Charles Dullin,
F-38100 Grenoble (FR)**

(74) Mandataire: **Mongrédien, André et al, c/o
BREVATOME 25, rue de Ponthieu, F-75008 Paris (FR)**

### Description

La présente invention concerne un dispositif de mise en tension d'une plaque mince comme décrit dans le préambule de la revendication 1. Elle s'applique notamment à la mise en tension d'un résistor plan pour l'élaboration de matériaux et plus généralement, à la mise en tension d'une plaque mince soumise à des contraintes thermiques, mécaniques, voire électriques, de façon à conserver cette plaque plane et tendue.

Par «plaque, ou lame mince», on entend donc notamment un résistor plan ou encore un feuillard porté à haute température par induction ou par chauffage capacitif par exemple.

On connaît des dispositifs de mise en tension d'une plaque ou lame mince, dans lesquels la plaque est mise en tension à froid entre deux pinces. De tels dispositifs présentent les inconvénients suivants: ils sont difficiles à régler et manquent de précision. En effet, ils ne permettent pas d'adjuster la tension en cours de chauffage. En outre, ils ne permettent pas de dévoiler la plaque mince qui, sous l'effet de diverses inhomogénéités, se voile, c'est-à-dire se gondole.

La présente invention a justement pour objet un dispositif de mise en tension d'une plaque mince, qui ne présente pas ces inconvénients, notamment en ce qu'il permet de réduire le voilage de la plaque mince et, dans certains modes de réalisation, de dévoiler totalement cette plaque.

On connaît déjà, par le document FR-A-2 067 923, un procédé de fabrication de monocristaux de calcite, par fusion et refroidissement de carbonate de calcium polycristallin en présence d'un mélange eutectique incluant du carbonate de lithium. Le carbonate polycristallin, pressé sous forme d'un barreau, est appliqué contre une pastille du mélange, elle-même appliquée sur un germe monocristallin, la pastille étant déplacée à l'état fondu le long du barreau sous l'influence d'un gradient mobile de température. La fusion de la pastille peut être obtenue par un ruban métallique percé dans sa région centrale.

On connaît également, par le document FR-A-2 251 368, un procédé de fabrication d'un monocristal à partir d'un barreau polycristallin, par déplacement, le long du barreau, d'une zone fondue appliquée sous forme de pastille entre le barreau et un germe monocristallin. La pastille est chauffée par un ruban métallique soumis à l'action d'un courant amené par deux électrodes fixées aux extrémités du ruban. Le ruban comporte dans sa région centrale une pluralité de trous.

On connaît aussi, par le document DE-C-571 849, une machine pour aplatir ou égaliser des tôles. Cette machine comprend un socle, un dispositif de traction réglable suivant la longueur de la tôle, ce dispositif étant fixé à une «fente». Un autre dispositif de traction est fixé à une «fente» de traction et se trouve tiré par une pièce d'un levier. Ce dernier porte un poids déplaçable mécaniquement ou manuellement. Des organes permettent de ramener le levier de sa position de travail dans sa position horizontale.

De façon précise, la présente invention a pour objet un dispositif de mise en tension d'une plaque mince dans un plan, ce dispositif comprenant au moins deux ensembles comprenant chacun des moyens de traction sur une extrémité de la plaque, suivant un axe de traction du plan, les ensembles étant disposés de façon que la plaque soit en équilibre sous l'effet des tractions, dispositif caractérisé en ce que chaque ensemble comprend un plateau parallèle au plan, en ce que ce plateau porte les moyens de traction associés à l'ensemble, ces moyens de traction comprenant des moyens de maintien de l'extrémité correspondant à l'ensemble et des moyens élastiques pour exercer la traction, et en ce que ces moyens de traction sont montés sur des moyens de rotation comprenant une platine mobile en rotation sur le plateau, autour d'un axe de rotation perpendiculaire au plateau.

La plaque mince peut avoir une forme quelconque, par exemple rectangulaire, carrée, cruciforme, triangulaire, plus généralement polygonale, ou même circulaire. On peut par exemple utiliser: dans le cas d'une lame en forme de rectangle, deux ensembles appliqués respectivement aux petits côtés du rectangle; dans le cas d'une lame en forme de triangle ou d'étoile à trois branches, trois ensembles respectivement appliqués aux côtés du triangle ou aux trois branches de l'étoile; dans le cas d'une lame en forme de croix, quatre ensembles respectivement appliqués aux quatre branches de la croix; dans le cas d'une lame en forme de cercle, une pluralité d'ensembles respectivement appliqués à des portions du pourtour de ce cercle et régulièrement espacés les uns des autres.

Les moyens de traction peuvent comporter en outre un chariot qui est déplaçable en translation, dans des moyens de guidage qui sont fixés sur ladite platine, suivant ledit axe de traction, ledit chariot étant rigidement solidaire des moyens de maintien, ledit axe de traction rencontrant ledit axe de rotation et lesdits moyens élastiques exerçant ladite traction sur le chariot.

Le plateau comprend par exemple deux galets ou pions, situés sur un cercle centré sur l'axe autour duquel la platine est mobile en rotation et la platine comprend alors deux lumières s'étendant sur des portions du cercle et traversées par les galets.

Selon un mode de réalisation particulier de l'invention, chaque ensemble comprend un autre plateau parallèle au plan et sur lequel le plateau correspondant à cet ensemble est déplaçable en translation perpendiculairement à la direction initiale de l'axe de traction associé à l'ensemble. Ce mode de réalisation particulier permet de dévoiler totalement la plaque mince lorsque celle-ci s'est voilée.

Dans une réalisation particulière de l'invention, chaque ensemble comprend en outre un plateau principal parallèle au plan et sur lequel l'autre plateau correspondant à cet ensemble est déplaçable en translation suivant la direction initiale de l'axe de traction associé à l'ensemble.

Selon un autre mode de réalisation particulier, dans chaque ensemble, ledit axe de rotation passe par le milieu de l'extrémité associée à cet ensemble. Le dispositif objet de l'invention peut alors être réalisé de façon assez simple, sans lesdits autres plateaux (formant des moyens de translation transverse), tout en permettant de dévoiler complètement la plaque lorsque celle-ci s'est voilée.

Enfin, dans un mode de réalisation particulier de l'invention, la plaque mince est conductrice de l'électricité et percée de trous et les moyens de maintien sont aptes à transmettre un courant électrique servant à chauffer la plaque mince et sont refroidis par circulation d'un fluide.

L'invention sera mieux comprise à la lecture de la description qui suit, d'exemples de réalisation donnés à titre indicatif et nullement limitatif, en référence aux dessins annexés sur lesquels:

La fig. 1 est une vue schématique d'un appareil pour la fabrication de matériaux tels que les cristaux ou les céramiques, par la méthode dite «du résistor plan»;

la fig. 2 est une vue schématique et partielle d'un mode de réalisation particulier du dispositif objet de l'invention, et

la fig. 3 est une vue schématique et partielle d'un autre mode de réalisation particulier du dispositif objet de l'invention.

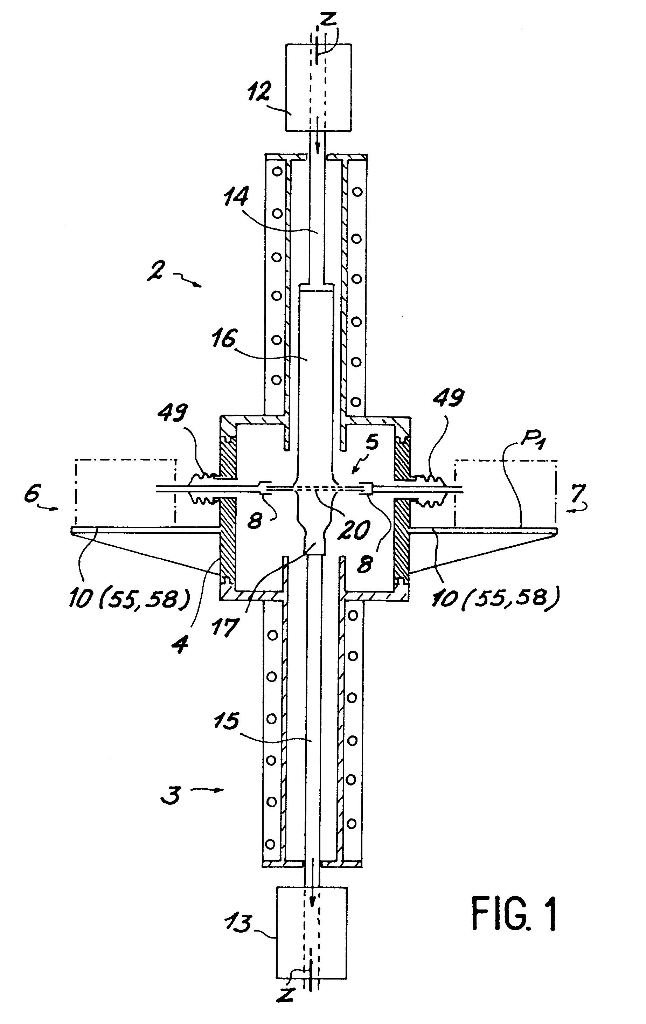

L'appareil schématiquement représenté sur la fig. 1 comporte essentiellement un four de préchauffage vertical 2 et un four de post-chauffage 3 vertical, au-dessous de four de préchauffage 2 et dans le prolongement de celui-ci. L'extrémité inférieure du four de préchauffage 2 et l'extrémité supérieure du four de post-chauffage 3 communiquent l'une avec l'autre par l'intermédiaire d'une virole 4 à laquelle elles sont toutes deux raccordées. Une résistance électrique plane 5, appelée «résistor» et constituée par une lame mince métallique par exemple en platine, pourvue de trous calibrés 20, est interposée entre les deux fours, à l'intérieur de la virole 4.

La lame 5 présente, à titre indicatif mais non limitatif, a forme d'un rectangle. Elle est alimentée en courant électrique par des moyens non représentés, de manière à être chauffée par effet Joule dans le cas présent (mais on pourrait utiliser tout autre type de chauffage, par haute fréquence par exemple).

La lame 5 est maintenue constamment plane et horizontale grâce à un dispositif selon l'invention comportant deux ensembles 6 et 7 constitués de la même façon. Ces deux ensembles 6 et 7 sont situés en regard l'un de l'autre à l'extérieur de la virole et sont prévus pour maintenir la lame 5 respectivement par les extrémités 8 les plus courtes de celles-ci.

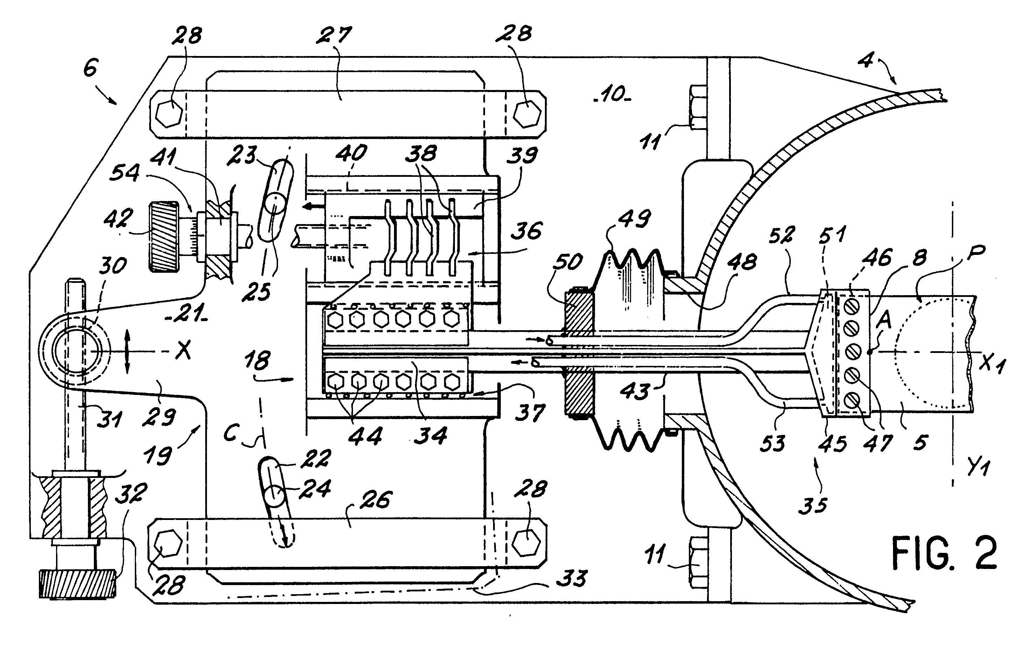

Chacun des deux ensembles 6 et 7 comporte notamment un plateau 10, ces deux plateaux étant fixés à la virole 4 dans un même plan horizontal $P_1$, par exemple à l'aide de boulons 11 (fig. 2). Compte tenu de l'identité des ensembles 6 et 7, seuls des modes de réalisation particuliers de l'un d'entre eux seront décrits par la suite.

L'appareil représenté schématiquement sur la fig. 1 comporte également deux systèmes de translation-rotation 12 et 13, l'un permettant de déplacer verticalement dans le four de préchauffage 2 une tige 14 et l'autre permettant de déplacer verticalement dans le four de post-chauffage 3 une autre tige 15 dans le prolongement de la tige 14.

L'appareil permet par exemple de fabriquer un monocristal d'un matériau tel que le niobate de lithium. Pour ce faire, un barreau cylindrique 16 du matériau est fixé à la tige 14 et un germe monocristallin 17 du matériau est fixé à la tige 15. Pour transformer le barreau 16 en un monocristal par la méthode du résistor plan, ce barreau et le germe 17 sont d'abord mis en contact avec le résistor 5 porté à la température de fusion du matériau, de sorte qu'il se forme une zone fondue entre le barreau et le germe, puis ces derniers sont simultanément et progressivement descendus de façon que la zone fondue se déplace le long du barreau, ce qui permet finalement d'obtenir un barreau monocristallin dont l'orientation cristalline est celle du germe. Le four de post-chauffage 3 permet d'effectuer un recuit du monocristal après l'élaboration de celui-ci.

Sur la fig. 2, on a représenté schématiquement un mode de réalisation particulier de l'un 6 des deux ensembles dont est composé le dispositif objet de l'invention, dans le cas particulier où celui-ci n'en comporte que deux, l'autre 7 étant constitué de la même façon que l'ensemble représenté. Ce dernier comprend essentiellement des moyens 18 de traction sur une extrémité 8 de la plaque 5 et des moyens 19 de rotation de cette extrémité 8 autour d'un axe vertical que l'on peut appeler «axe de rotation» et qui est repéré sur la fig. 2 par son point d'intersection A avec la plaque 5, cet axe de rotation portant la référence A par la suite.

Les moyens 19 de rotation comprennent une platine 21 mobile en rotation sur le plateau horizontal 10, autour de l'axe de rotation A. La platine 21 comporte deux lumières 22 et 23 s'étendant sur des portions d'un cercle C dont l'axe est l'axe de rotation A, ce dernier étant ainsi défini par la forme des lumières 22 et 23. Le plateau 10 comprend deux galets ou pions 24 et 25 disposés de façon à traverser respectivement les lumières 22 et 23 et à autoriser la rotation de la platine autour de l'axe A. On peut alors dire que les galets 24 et 25 coulissent dans les lumières 22 et 23 ou que ces dernières sont guidées en rotation par les galets 24 et 25. La platine 21 est maintenue au contact du plateau 10 par des ponts de retenue 26 et 27 enjambant respectivement les bords de la platine qui encadrent les deux lumières 22 et 23. Ces ponts sont fixés au plateau 10 à l'aide de boulons 28 par exemple.

La platine 21 comprend également un levier 29 s'étendant horizontalement à l'opposé de l'axe de rotation A par rapport aux lumières 22 et 23 et à équidistance de celles-ci. Une noix pivotante 30 est montée à l'extrémité du levier 29. Une vis 31 commandée en rotation par un bouton moleté 32 et prisonnière du plateau 10, coopère avec la noix pivotante 30, par vissage dans celle-ci, pour déplacer la platine 21 en rotation autour de l'axe A grâce aux lumières 22 et 23 guidées par les galets 24 et 25. Sur la fig. 2, on a représenté par un trait mixte 33 un déplacement possible pour la platine 21. Ladite rotation est bien entendu limitée par la longueur des lumières.

Les moyens 18 de traction comprennent un chariot 34 déplaçable en translation sur la platine 21 suivant un axe horizontal X, des moyens 35 de maintien de l'extrémité 8 de la plaque 5, ces moyens de maintien étant rendus rigidement solidaires du chariot 34, et des moyens élastiques 36 pour exercer la traction sur le chariot 34. Ce chariot se déplace en translation, sans frottement, dans une glissière à roulements 37, fixée sur la platine 21. La glissière 37 est disposée de façon que l'axe horizontal de traction ou de translation X s'étende le long du rayon du cercle C, équidistant des deux lumières 22 et 23, de façon que l'axe de translation X rencontre l'axe de rotation A.

Les moyens élastiques 36 comprennent par exemple des lames-ressorts 38 parallèles entre elles ainsi qu'un autre chariot 39 adjacent au chariot 34 et déplaçable parallèlement à celui-ci dans une autre glissière 40 montée sur la platine 21, les lames-ressorts 38 étant rigidement fixées aux chariots 34 et 39, transversalement à l'axe de translation X. La translation de l'autre chariot 39 est commandée à l'aide d'une autre vis 41 qui est prisonnière de la platine 21, disposée parallèlement à l'axe de translation X et pourvue d'un bouton moleté 42 permettant de commander la rotation de la vis.

Les moyens 35 de maintien comportent un tirant 43 qui s'étend le long de l'axe de translation X et dont une extrémité est fixée sur le chariot 34 au moyen de vis 44, tandis que son autre extrémité porte une pince 45 dont les mâchoires 46 maintiennent l'extrémité 8 de la lame 5 par exemple à l'aide de vis 47 qui traversent l'une des mâchoires et dont le serrage emprisonne la lame 5 entre ces vis et l'autre mâchoire. La lame 5 est immobilisée par les pinces des ensembles 6 et 7 (fig. 1) de façon à pouvoir exercer une traction longitudinale sur cette lame grâce aux moyens 18 de traction. Les bords des mâchoires 46 sont perpendiculaires à l'axe de translation X (fig. 2) et délimitent l'extrémité «apparente» ou «effective» de la lame 5. Les lumières 22 et 23 sont réalisées de façon que le point A soit le milieu de cette extrémité effective, c'est-à-dire que l'axe de rotation A passe par le milieu de celle-ci que l'on peut seulement appeler «extrémité» pour plus de simplicité.

En face de l'ensemble 6 est prévue une ouverture 48 pratiquée dans le virole 4. Cette ouverture 48 est raccordée de façon étanche à un soufflet 49, lui-même fermé de façon étanche par une plaque 50 électriquement isolante. Le tirant 43 traverse la plaque 50 dont il est rendu solidaire.

La lame 5 est alimentée en courant électrique à travers les plaques 50, grâce à un générateur de courant non représenté. A titre d'exemple, l'alimentation en courant électrique se fait par les lames-ressorts 38, le tirant 43 et la pince 45, ces différents éléments comportant des parties électriquement conductrices reliées les unes aux autres et convenablement isolées électriquement du reste du dispositif pour que les utilisateurs de celui-ci ne courent aucun risque. Lesdits éléments sont conçus pour pouvoir propager un courant électrique dépassant 200 A et l'isolation électrique est réalisée en conséquence.

La pince 45 est refroidie par circulation d'un fluide tel que l'eau et comporte à cette fin une partie creuse 51 dans laquelle débouchent des conduits 52 et 53 qui sont respectivement prévus pour l'arrivée et l'évacuation du fluide et qui traversent la plaque 50.

Bien entendu, ce qui vient d'être dit à propos de l'ouverture 48, du soufflet 49, de l'alimentation en courant électrique et du refroidissement par un fluide, est également vrai pour l'autre ensemble 7 (fig. 1).

Le montage de la lame 5 et l'installation du dispositif selon l'invention sont effectués de la façon suivante: la virole 4 étant séparée des fours 2 et 3 (fig. 1), la lame 5 est immobilisée dans les pinces 45 correspondant respectivement aux deux ensembles. La virole 4 est mise en place entre les fours 2 et 3. Les plateaux 10 sont alors montés sur la virole 4. Ils comprennent les différents organes de translation et de rotation décrits précédemment, notamment les chariots 34. On peut alors fixer les tirants 43 à leurs chariots respectifs 34.

Les lames-ressorts 38 exercent une traction sur les chariots 34 et donc sur la lame 5 qui est ainsi mise en tension. L'action sur les boutons 42 permet de régler la force de tension de la lame 5. Cette force de tension peut être mesurée en adjoignant à chaque vis 41 des moyens de repérage par exemple constitués par un vernier avec bague de remise à zéro 54.

Lorsque la lame 5 est chauffée, elle subit un allongement qui est compensé grâce aux moyens 18 de traction. La lame 5 peut également subir un voilage que l'on supprime en agissant sur les moyens 19 de rotation, par l'intermédiaire des boutons 32. Le dispositif selon l'invention, représenté sur la fig. 2, permet ainsi de maintenir constamment la lame 5 dans un plan horizontal P.

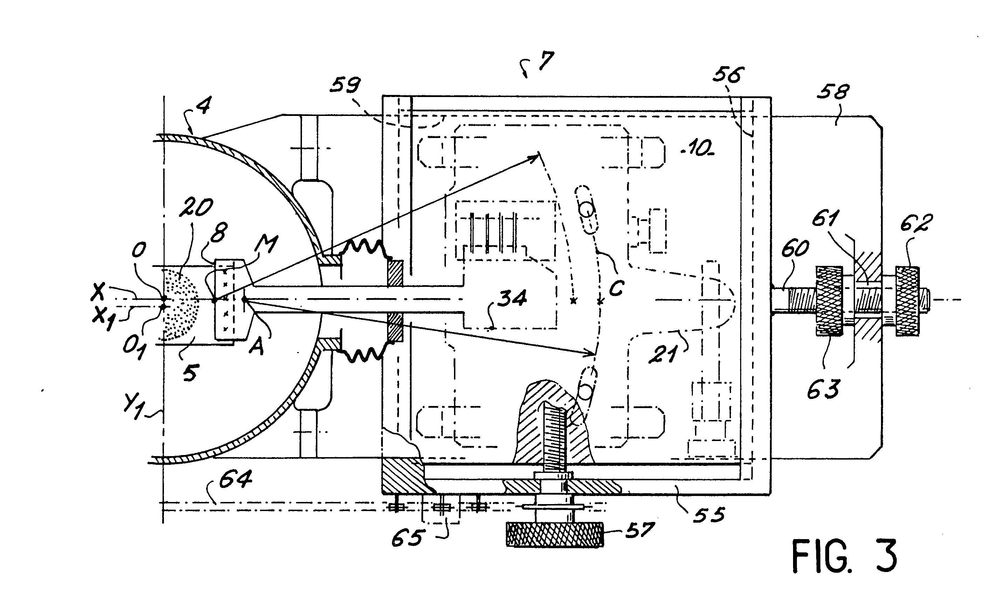

Sur la fig. 3, on a représenté schématiquement un autre mode de réalisation particulier de l'invention, correspondant au cas où l'axe de rotation A ne passe pas par le milieu de l'extrémité 8 de la lame 5, milieu qui est repéré par la lettre M sur la fig. 3. En fait, on a seulement représenté sur cette figure une partie du dispositif, correspondant à l'ensemble 7, l'ensemble 6 étant constitué de la même façon que cet ensemble 7. Cet autre mode de réalisation particulier diffère essentiellement du mode de réalisation précédemment décrit en ce qu'il comprend en outre des moyens de translation transverse, permettant de déplacer l'extrémité 8 de la lame 5 suivant une direction horizontale et perpendiculaire à un axe $X_1$ de référence précisé plus loin, avec lequel l'axe de traction X coïncide initialement (c'est-à-dire avant toute rotation de la platine, effectuée en vue d'un dévoilage). Dans cet autre mode de réalisation particulier, le plateau 10 qui était précédemment fixe par rapport à la virole 4 ne l'est plus. Il est remplacé, dans sa position précédente, par un autre plateau horizontal 55 qui est donc fixe par rapport à la virole 4. Le plateau horizontal 10 est quant à lui déplaçable en translation perpendiculairement à l'axe de référence $X_1$ sur l'autre plateau 55, dans une glissière 56 dont est pourvu l'autre plateau 55. Le plateau 10 associé à la glissière 56, constitue ainsi les moyens de translation transverse, cette translation transverse étant effectuée par une commande à vis 57.

L'adjonction des moyens de translation transverse de l'extrémité 8 de la lame 5 permet de dévoiler cette lame bien que l'axe de rotation A ne passe pas par le milieu M de l'extrémité 8. Le dévoilage de la lame s'effectue alors non seulement par une rotation appropriée d'au moins l'une des deux platines 21, mais encore par une translation transverse appropriée d'au moins l'un des deux plateaux 10.

Les moyens de translation transverse précédemment décrits permettent également un recentrage latéral de la lame 5. (L'axe vertical Z de l'appareil décrit en référence à la fig. 1 est en effet repéré par un point $O_1$ sur la fig. 3, lui-même défini par l'intersection de deux axes de référence $X_1$ et $Y_1$ horizontaux et perpendiculaires. Initialement, le centre O de la lame 5 coïncide avec le point $O_1$ et l'axe X de traction coïncide avec l'axe de référence $X_1$. Le recentrage latéral de la lame consiste à replacer le centre O sur l'axe $X_1$ par translation transverse du plateau 10, lorsque le centre O c'est écarté de l'axe $X_1$).

On peut également avoir besoin d'effectuer un recentrage longitudinal de la lame 5. Pour ce faire, on modifie l'ensemble 7 représenté sur la fig. 3 de la façon suivante, l'ensemble 6 étant modifié de la même façon: l'autre plateau 55 qui était précédemment fixe par rapport à la virole 4 ne l'est plus. Il est remplacé, dans sa position précédente, par un plateau principal horizontal 58 qui est donc fixe par rapport à la virole 4. L'autre plateau horizontal 55 est quant à lui déplaçable en translation parallèlement à l'axe de référence $X_1$, par rapport au plateau principal 58, dans une glissière 59 montée à cet effet sur le plateau principal 58. Une vis horizontale 60 est fixée sur l'autre plateau 55, à l'opposé de la lame 5 par rapport à cet autre plateau 55. La vis 60 traverse une ouverture 61 pratiquée dans le plateau principal 58. Cette vis 60 est pourvue d'une paire d'écrous moletés 62 et 63 permettant le réglage en translation et l'immobilisation de l'autre plateau 55 par rapport au plateau principal 58.

Lorsque la lame 5 est plane mais excentrée, on peut la recentrer par translation transverse des plateaux 10 et par translation longitudinale des autres plateaux 55. Alors, pour ne pas modifier le réglage des platines 21 qui a permis d'obtenir la planéité de la lame 5, on peut rendre solidaires en translation transverse les plateaux 10, à l'aide d'une chaîne de transmission 64 reliant les vis 57 de façon que la rotation d'une vis 57 d'un certain angle provoque la rotation de l'autre vis 57, du même angle et dans le même sens. La chaîne 64 est munie d'un tendeur 65 permettant des translations longitudinales indépendantes, des autres plateaux 55.

Pour les dispositifs selon l'invention décrits précédemment, la référence à un plan horizontal n'a été faite qu'en raison du cas particulier du résistor plan. La lame mince peut être maintenue en tension dans un plan vertical ou autre avec des dispositifs identiques mais convenablement orientés.

De plus, dans la description des fig. 1 à 3, la lame a été supposée rectangulaire. Ceci n'est qu'un exemple donné à titre indicatif et nullement limitatif: l'invention permet de maintenir plane une lame mince de forme quelconque. Il suffit pour cela d'utiliser un nombre suffisant d'ensembles tels que ceux qui ont été décrits en référence à la fig. 2 ou 3. Par exemple, dans le cas d'une lame ayant la forme d'un polygone, on peut associer un ensemble à chaque côté de ce polygone. Dans le cas d'une lame en forme de croix, on peut utiliser quatre ensembles respectivement associés aux branches de la croix.

Enfin, dans la description des fig. 2 et 3, on a considéré le cas où les moyens de rotation sont reliés à la lame mince par l'intermédiaire des moyens de traction. On peut bien entendu réaliser des dispositifs selon l'invention correspondant au cas inverse.

## Revendications

1. Dispositif de mise en tension d'une plaque mince (5) dans un plan (P), ce dispositif comprenant au moins deux ensembles (6, 7) comprenant chacun des moyens (18) de traction sur une extrémité (8) de la plaque, suivant un axe de traction (X) du plan, les ensembles étant disposés de façon que la plaque (5) soit en équilibre sous l'effet des tractions, dispositif caractérisé en ce que chaque ensemble (6, 7) comprend un plateau (10) parallèle au plan (P), en ce que ce plateau (10) porte les moyens de traction (18) associés à l'ensemble, ces moyens de traction comprenant des moyens (35) de maintien de l'extrémité correspondant à l'ensemble et des moyens élastiques (36) pour exercer la traction, et en ce que ces moyens (18) de traction sont montés sur des moyens (19) de rotation comprenant une platine (21) mobile en rotation sur le plateau, autour d'un axe de rotation (A) perpendiculaire au plateau.

2. Dispositif selon la revendication 1, caractérisé en ce que chaque ensemble (6, 7) comprend un autre plateau (55) parallèle au plan (P) et sur lequel le plateau (10) correspondant à cet ensemble est déplaçable en translation perpendiculairement à la direction initiale de l'axe de traction (X) associé à l'ensemble.

3. Dispositif selon la revendication 2, caractérisé en ce que chaque ensemble (6, 7) comprend en outre un plateau principal (58) parallèle au plan et sur lequel l'autre plateau (55) correspondant à cet ensemble est déplaçable en translation suivant la direction initiale de l'axe (X) de traction associé à l'ensemble.

4. Dispositif selon l'une quelconque des revendications 1 à 3, caractérisé en ce que les moyens (18) de traction comportent en outre un chariot (34) qui est déplaçable en translation, dans des moyens de guidage (37) qui sont fixés sur ladite platine (21), suivant ledit axe de traction (X), ledit chariot (34) étant rigidement solidaire des moyens (35) de maintien, ledit axe de traction (X) rencontrant ledit axe de rotation (A) et lesdits moyens élastiques (36) exerçant ladite traction sur le chariot (34).

5. Dispositif selon l'une quelconque des revendications 1 à 4, caractérisé en ce que le plateau (10) comprend deux galets (24, 25) situés sur un cercle (C) centré sur l'axe (A) autour duquel la platine est mobile en rotation et en ce que la platine (21) comprend deux lumières (22, 23) s'étendant sur des portions du cercle et traversées par les galets.

6. Dispositif selon la revendication 1, caractérisé en ce que dans chaque ensemble (6, 7), l'axe (A) de rotation passe par le milieu (M) de l'extrémité (8) associée à cet ensemble.

7. Dispositif selon l'une quelconque des revendications 1 à 6, caractérisé en ce que la plaque mince (5) est conductrice de l'électricité et percée de trous (20) et en ce que les moyens (35) de maintien sont aptes à transmettre un courant électrique servant à chauffer la plaque mince (5) et sont refroidis par circulation d'un fluide.

8. Application du dispositif selon l'une quelconque des revendications 1 à 7, à la mise en tension d'un résistor plan pour l'élaboration de matériaux, ce résistor étant constitué d'une plaque mince, conductrice de l'électricité et percée de trous.

## Claims

1. Device for tensioning a thin plate (5) in a plane (P), said device comprising at least two assemblies (6, 7), each comprising tensioning means (18) on one end (8) of the plate in a tension axis (X) of the plane, the assemblies being arranged in such a way that plate (5) is in equilibrium under the effect of the tensions, characterized in that each assembly (6, 7) comprises a plate (10) parallel to plane (P), in that plate (10) carries the tensioning means (18) associated with the assembly, said tensioning means comprising means (35) for holding the end corresponding to the assembly and elastic means (36) for exerting tension and in that the tensioning means (18) are mounted on rotation means (19) comprising a base plate (21) rotatable on plate (10), about a rotation axis (A) perpendicular to plate (10).

2. Device according to claim 1, characterized in that each assembly (6, 7) comprises another plate (55) parallel to plane (P) and on which the plate (10) corresponding to said assembly is displaceable in translation perpendicular to the initial direction of tension axis (X) associated with the assembly.

3. Device according to claim 2, characterized in that each assembly (6, 7) also comprises a main plate (58) parallel to the plane and on which the other plate (55) corresponding to said assembly is displaceable in translation in the initial direction of the tension axis (X) associated with the assembly.

4. Device according to any one of the claims 1 to 3, characterized in that the tensioning means (8) also incorporate a carriage (34) displaceable in translation in guidance means (37), which are fixed to said base plate (21) in accordance with said tension axis (X), carriage (34) being rigidly integral with the holding means (35), said tension axis (X) encountering said rotation axis (A) and said elastic means (36) exerting said tension on carriage (34).

5. Device according to any one of the claims 1 to 4, characterized in that plate (10) comprises two rollers (24, 25) located on a circle (C) centred on axis (A) about which the base plate is mobile in rotation and in that base plate (21) comprises two openings (22, 23) extending over portions of the circle and traversed by rollers.

6. Device according to claim 1, characterized in that each assembly (6, 7), the rotation axis (A) passes through the centre (M) of the end (8) associated with said assembly.

7. Device according to any one of the claims 1 to 6, characterized in that the thin plate (5) conducts electricity and has holes (20) in it and in that the holding means (35) can transmit an electric current for heating the thin plate (5) and are cooled by the circulation of a fluid.

8. Application of the device according to any one of the claims 1 to 7 to the tensioning of a flat resistor for producing materials, said resistor being constituted by a thin plate, which conducts electricity and contains holes.

## Patentansprüche

1. Vorrichtung zum Spannen einer dünnen Platte (5) in einer Ebene (P), wobei diese Vorrichtung wenigstens zwei Einheiten (6, 7) umfasst, von denen jede Einrichtung (18) für einen Zug auf ein Ende (8) der Platte längs einer Zugachse (X) der Ebene aufweist und die Einheiten derart angeordnet sind, dass sich die Platte (5) unter der Zugwirkung im Gleichgewicht befindet, dadurch gekennzeichnet, dass jede Einheit (6, 7) eine zu der Ebene (P) parallele Platte (10) aufweist, dass diese Platte (10) die der Einheit zugeordneten Zugeinrichtungen (18) trägt, die Zugeinrichtungen Halteeinrichtungen (35) für das der Einheit entsprechende Ende und elastische Einrichtungen zum Ausüben des Zugs umfassen und dass diese Zugeinrichtungen (18) an Dreheinrichtungen (19) angebracht sind, die eine auf der Platte um eine zu der Platte senkrechte Drehachse (A) drehbewegliche Halteplatte aufweisen.

2. Vorrichtung nach Anspruch 1, dadurch gekennzeichnet, dass jede Einheit (6, 7) eine andere Platte (55) aufweist, die zu der Ebene (P) parallel ist, und auf der die dieser Einheit entsprechende Platte (10) senkrecht zu der Anfangsrichtung, der dieser Einheit zugeordneten Zugachse (X) quer verschiebbar ist.

3. Vorrichtung nach Anspruch 2, dadurch gekennzeichnet, dass jede Einheit (6, 7) ferner eine Hauptplatte (58) aufweist, die parallel zu der Ebene ist und auf der die dieser Einheit entsprechende, andere Platte (55) in Anfangsrichtung der der Einheit zugeordneten Zugachse (X) verschiebbar ist.

4. Vorrichtung nach irgendeinem der Ansprüche 1 bis 3, dadurch gekennzeichnet, dass die Zugeinrichtungen (18) ferner einen in auf der Halteplatte (21) befestigten Führungsmitteln (37) längs der Zugachse (X) verschiebbaren Wagen (34) aufweisen, der steif mit den Halteeinrichtungen (35) verbunden ist, wobei sich die Zugachse (X) und die Drehachse (A) schneiden und die elastischen Einrichtungen (36) den genannten Zug auf den Wagen (34) ausüben.

5. Vorrichtung nach irgendeinem der Ansprüche 1 bis 4, dadurch gekennzeichnet, dass die Platte (10) zwei Rollen (24, 25) aufweist, die sich auf einem Kreis (C) befinden, der auf der Achse (A) zentriert ist, um die die Halteplatte drehbeweglich ist, und dass die Halteplatte (21) zwei Längsöffnungen (22, 23) aufweist, die sich über Abschnitte des Kreises erstrecken und von den Rollen durchquert sind.

6. Vorrichtung nach Anspruch 1, dadurch gekennzeichnet, dass in jeder Einheit (6, 7) die Drehachse (A) durch die Mitte (M) des dieser Einheit zugeordneten Endes (8) hindurchgeht.

7. Vorrichtung nach irgendeinem der Ansprüche 1 bis 6, dadurch gekennzeichnet, dass die dünne Platte (5) elektrisch leitend und von Löchern (20) durchbohrt ist und dass die Halteeinrichtungen (35) einen elektrischen Strom zum Heizen der dünnen Platte (5) übertragen können und durch eine Fluidströmung gekühlt sind.

8. Anwendung der Vorrichtung nach irgendeinem der Ansprüche 1 bis 7, zum Spannen eines ebenen Widerstands zur Untersuchung von Materialien, wobei dieser Widerstand von einer dünnen, elektrisch leitenden und mit Löchern durchbohrten Platte gebildet ist.

FIG. 1

FIG. 2

FIG. 3